# EUROPÄISCHE PATENTANMELDUNG

(11) **EP 2 804 210 A1**
(43) Veröffentlichungstag der Anmeldung: **19.11.2014**
(21) Anmeldenummer: 14158699.0
(22) Anmeldetag: 11.03.2014
(51) Int. Cl.: H01L 25/04

(54) **Leistungselektronische Schalteinrichtung und Anordnung hiermit**

(30) Priorität: 14.05.2013 DE 102013104949
(71) Anmelder: SEMIKRON Elektronik GmbH & Co. KG, 90431 Nürnberg (DE)
(72) Erfinder: Göbl, Christian, 90441 Nürnberg (DE)

(57) **Zusammenfassung**

Es wird ein Schalteinrichtung mit einem Substrat, einem

Leistungshalbleiterbauelement, einer Verbindungseinrichtung, Lastanschlusseinrichtungen und einer Druckeinrichtung vorgestellt. Hierbei weist das Substrat elektrisch isolierte Leiterbahnen auf und auf einer Leiterbahn ist ein Leistungshalbleiterbauelement angeordnet. Die Verbindungseinrichtung ist als Folienverbund mit einer elektrisch leitenden und einer elektrisch isolierenden Folie ausgebildet und weist eine erste und eine zweite Hauptfläche. Hiermit wird die Schalteinrichtung intern schaltungsgerecht verbunden. Die Druckeinrichtung weist einen Druckkörper mit einer ersten Ausnehmung auf aus der ein Druckelement hervorstehend angeordnet ist, wobei das Druckelement auf einen Abschnitt der zweiten Hauptfläche des Folienverbunds drückt und hierbei dieser Abschnitt in Projektion entlang der Normalenrichtung des Leistungshalbleiterbauelements innerhalb der Fläche des Leistungshalbleiterbauelements angeordnet ist.

## Beschreibung

Die Erfindung beschreibt eine leistungselektronische Schalteinrichtung, die eine Basiszelle eines Leistungshalbleitermoduls oder eines leistungselektronischen Systems ausbilden kann, indem sie alleine oder in Kombination mit weiteren vorzugsweise identischen Basiszellen den leistungselektronischen Grundbaustein des Leistungshalbleitermoduls oder des leistungselektronischen Systems bildet.

Aus dem Stand der Technik, beispielhaft offenbart in der DE10 2010 62 556 A1, ist eine Halbleiterschaltungsanordnung in Form eines Leistungshalbleitermoduls bekannt, bei der ein Gehäuse Druckelemente mit einem Druckkörper aufweist, wobei der Druckkörper entweder direkt auf einen Teil eines Halbleiterbauelement oder auf einen Abschnitt eines Substrats drückt. Aus der US 7,808,100 B2 ist es ebenfalls bekannt direkt mittels eines Pressstempels auf Leistungshalbleiterbauelemente zu drücken. Nachteilig an beiden Ausgestaltungen ist, dass ein direkter Druck auf ein Leistungshalbleiterbauelement, das mittels Drahtbondverbindungen intern schaltungsgerecht verbunden ist auf Grund der in realen Anwendungen begrenzten zur Verfügung stehenden Fläche nur sehr punktuell erfolgen kann. Somit verringert sich die Stromtragfähigkeit der internen Verbindung, da am Druckpunkt keine Bondverbindungen herstellbar sind.

Ebenfalls dem relevanten Stand der Technik zuzuordnen ist die DE 10 2007 006 706 A1, die eine Schaltungsanordnung mit einem Substrat, hierauf angeordneten Leiterbahnen und hierauf angeordneten Halbleiterbauelementen beschreibt. Eine interne Verbindungseinrichtung ist als ein Folienverbund ausgebildet, der ein Leistungshalbleiterbauelement mit einer Kontaktfläche einer Leiterbahn verbindet. Hierbei ein Isolierstoff am Rand des Halbleiterbauelements angeordnet.

Beispielhaft aus der DE 10 2006 006 425 A1 ist es bekannt ein Leistungshalbleitermodul derart auszubilden, dass Druckeinrichtungen, ausgebildet als Lastanschlusselemente mit jeweils einer Mehrzahl von Kontaktfüßen auf Kontaktstellen eines Substrats Druck ausüben, um einen thermisch leitenden Kontakt zwischen dem Substrat und einer Kühleinrichtung herzustellen. Nachteilig hierbei ist allerdings, dass trotz einer Mehrzahl von Druck ausübenden Kontaktfüßen die thermisch Anbindung nicht optimal ausgebildet ist, da die thermische Anbindung der Abwärme erzeugenden Leistungshalbleiterbauelement nur mittelbar erfolgt.

In Kenntnis der genannten Gegebenheiten liegt der Erfindung die Aufgabe zugrunde, eine leistungselektronische Schalteinrichtung und eine Anordnung hiermit vorzustellen, wobei die Schalteinrichtung vielfältig einsetzbar ist und als Basiszelle eine optimale thermisch Druckanbindung an eine Kühleinrichtung gewährleistet.

Diese Aufgabe wird erfindungsgemäß gelöst durch eine leistungselektronische Schalteinrichtung mit den Merkmalen des Anspruchs 1, sowie durch eine Anordnung mit einer leistungselektronischen Schalteinrichtung mit den Merkmalen des Anspruchs 12. Bevorzugte Ausführungsformen sind in den jeweiligen abhängigen Ansprüchen beschrieben.

Die erfindungsgemäße Schalteinrichtung ist ausgebildet als eine leistungselektronische Schalteinrichtung mit einem Substrat, einem hierauf angeordneten Leistungshalbleiterbauelement, einer Verbindungseinrichtung, Lastanschlusseinrichtungen und einer Druckeinrichtung, wobei das Substrat gegeneinander elektrisch isolierte Leiterbahnen aufweist und auf einer Leiterbahn ein Leistungshalbleiterbauelement angeordnet und stoffschlüssig damit verbunden ist, wobei die Verbindungseinrichtung als Folienverbund mit einer elektrisch leitenden und einer elektrisch isolierenden Folie ausgebildet ist und somit eine erste und eine zweite Hauptfläche ausbildet und wobei die Schalteinrichtung mittels der Verbindungseinrichtung intern schaltungsgerecht verbunden ist, wobei die Druckeinrichtung einen Druckkörper mit einer ersten Ausnehmung aufweist aus der ein Druckelement hervorstehend angeordnet ist und wobei das Druckelement auf einen Abschnitt der zweiten Hauptfläche des Folienverbunds drückt und hierbei dieser Abschnitt in Projektion entlang der Normalenrichtung des Leistungshalbleiterbauelements innerhalb der Fläche des Leistungshalbleiterbauelements angeordnet ist.

Selbstverständlich handelt es sich bei dem Leistungshalbleiterbauelement um mindestens ein Leistungshalbleiterbauelement, wobei mehrere Leistungshalbleiterbauelemente auf einer oder mehreren Leiterbahnen angeordnet sein können.

Bevorzugt ist es, wenn die Ausnehmung des Druckkörpers als ausschließlich Vertiefung ausgehend von einer ersten Hauptfläche oder als Vertiefung ausgehend von der ersten Hauptfläche mit einer durch den Druckkörper zur zweiten Hauptfläche hindurchreichenden Aussparung mit dort angeordneter Öffnung ausgebildet ist. Hierbei kann das Druckelement die Ausnehmung des Druckkörpers vollständig oder annährend vollständig ausfüllen. Alternativ, gleichzeitig oder zusätzlich kann das Druckelement aus der Aussparung des Druckkörpers an dessen zweiten Hauptfläche hervorstehen.

In einer besonders bevorzugten Ausführung kann der Druckkörper aus einem hochtemperaturbeständigen thermoplastischen Kunststoff, insbesondere aus Polyphenylensulfid, und das Druckelement aus einem Silikonkautschuk, insbesondere aus Flüssig-Silikon, bestehen.

Zur Ausbildung einer effizienten Druckeinrichtung, deren Belastung für das Leistungshalbleiterbauelement nicht zu dessen Zerstörung führt ist es besonders vorteilhaft, wenn der Flächeninhalt des Abschnitts mindestens 20%, insbesondere mindestens 50% der Fläche des Leistungshalbleiterbauelements aufweist.

Im Sinne einer Basiszelle ist es weiterhin bevorzugt, wenn die laterale Ausdehnung der Druckeinrichtung in beide orthogonalen Richtungen parallel zur Substratebene geringer ist als die laterale Ausdehnung des Substrats als solches.

Auch kann es zur Ausbildung eines besonderen Schutzes gegen Umwelteinflüsse notwendig sein, wenn die Oberseite des Substrats, einschießend dessen Leiterbahnen, das Leistungshalbleiterbauelement und die Verbindungseinrichtung mittels einer Vergussmasse feuchtigkeitsdicht vergossen ist.

Erfindungsgemäß ausgebildet ist die Anordnung mit einer vorbeschriebenen elektronischen Schalteinrichtung, mit einer Kühleinrichtung und mit einer Druckeinleiteinrichtung, wobei die Druckeinleiteinrichtung sich mittelbar oder unmittelbar gegen die Kühleinrichtung abstützt, mittig auf die Druckeinrichtung Druck einleitet und hierdurch die Schalteinrichtung kraftschlüssig mit der Kühleinrichtung verbunden ist. Hierbei kann unter einer Kühleinrichtung insbesondere eine Grundplatte oder bevorzugt ein Kühlköper verstanden werden.

Ebenso ist es auf Grund der besonders wirksamen Druckeinleitung möglich, dass zwischen Substrat, insbesondere demjenigen Teil des Substrats, auf dem die Leistungshalbleiterbauelemente angeordnet sind, und der Kühleinrichtung eine Wärmeleitpaste mit einer Dicke von weniger als 20µm, insbesondere von weniger als 10µm, insbesondere von weniger als 5µm angeordnet werden kann.

Es ist besonders bevorzugt, wenn das Verhältnis aus lateraler Ausdehnung zu vertikaler Ausdehnung des Druckkörpers vor der Anordnung mit einer Kühleinrichtung ein Verhältnis von 2 zu 1, insbesondere von 4 zu 1 aufweist und nach dieser Anordnung mit einhergehender Druckbeaufschlagung ein Verhältnis von 3 zu 1, insbesondere von 5 zu 1 aufweist

Es versteht sich, dass die verschiedenen Ausgestaltungen der Erfindung einzeln oder in beliebigen Kombinationen realisiert sein können, um Verbesserungen zu erreichen. Insbesondere sind die vorstehend genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterung der Erfindung, vorteilhafte Einzelheiten und Merkmale, ergeben sich aus der nachfolgenden Beschreibung der in den Fig. 1 bis 8 dargestellten Ausführungsbeispiele der erfindungsgemäßen Anordnung oder von Teilen hiervon.
Figur 1 zeigt eine erste Ausgestaltung einer erfindungsgemäßen leistungselektronischen Schalteinrichtung.
Figur 2 zeigt diese erste Ausgestaltung einer erfindungsgemäßen Anordnung mit dieser leistungselektronischen Schalteinrichtung.
Figur 3 zeigt eine Druckeinrichtung einer zweite Ausgestaltung einer leistungselektronischen Schalteinrichtung.
Figuren 4 bis 6 zeigen verschiedene Ausgestaltungen von Teilen der Druckeinrichtung.
Figur 7 zeigt eine Draufsicht auf eine leistungselektronische Schalteinrichtung in verschiedenen Schnittebenen.
Figur 8 zeigt eine zweite Ausgestaltung einer erfindungsgemäßen leistungselektronischen Schalteinrichtung.

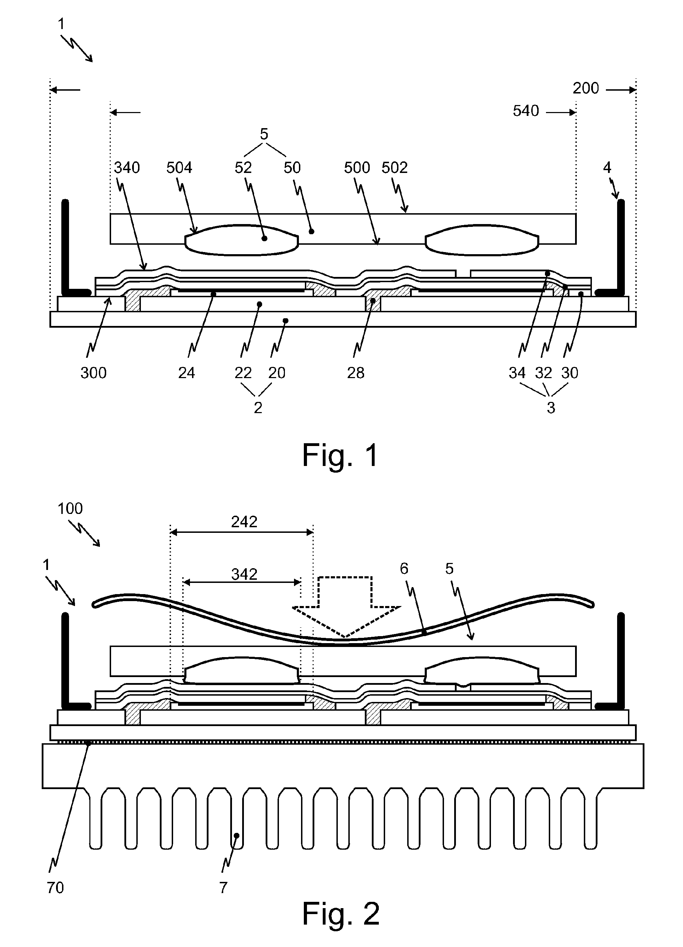

Figur 1 zeigt eine erste Ausgestaltung einer erfindungsgemäßen leistungselektronischen Schalteinrichtung 1. Dargestellt ist ein grundsätzlich fachüblich ausgebildetes Substrat 2 mit einem Isolierstoffkörper 20 und hierauf angeordneten jeweils elektrisch voneinander isolierten Leiterbahnen 22, die unterschiedliche Potentiale, insbesondere Lastpotentiale, aber auch Hilfs-, insbesondere Schalt- und Messpotentiale, der Schalteinrichtung aufweisen. Konkret dargestellt sind hier drei Leiterbahnen 22 mit Lastpotentialen wie sie für eine Halbbrückentopologie typisch sind.

Auf zwei Leiterbahnen 22 ist jeweils ein Leistungsschalter 24 angeordnet, der fachüblich als Einzelschalter, beispielhaft als MOS-FET, oder als IGBT mit antiparallel geschalteter Leistungsdiode, die hier dargestellt sind, ausgebildet sein. Die Leistungsschalter 24 sind fachüblich, bevorzugt mittels einer Sinterverbindung, mit den Leiterbahnen 22 elektrisch leitend verbunden.

Die internen Verbindungen der Schalteinrichtung 1 sind ausgebildet mittels einer Verbindungseinrichtung 3 aus einem Folienverbund, der alternierend elektrisch leitende 30, 34 und elektrisch isolierende Folien 32 aufweist. Hier weist der Folienverbund genau zwei leitende und eine dazwischen angeordnete isolierende Folie auf. Die dem Substrat 2 zugewandte Oberfläche des Folienverbunds 3 bildet hierbei die erste Hauptfläche aus, während die gegenüberliegende die zweite Hauptfläche 340 ausbildet. Insbesondere die leitenden Folien 30, 34 der Verbindungseinrichtung 3 sind in sich strukturiert und bilden somit voneinander elektrisch isolierte Leiterbahnabschnitte aus. Diese Leiterbahnabschnitte verbinden insbesondere das jeweilige Leistungshalbleiterbauelement 24, genauer dessen Kontaktflächen auf der dem Substrat 2 abgewandten Seite, mit Leiterbahnen 22 des Substrats. In bevorzugter Ausgestaltung sind die Leiterbahnabschnitte mit den Kontaktflächen mittels einer Sinterverbindung stoffschlüssig verbunden. Selbstverständlich können gleichartig auch Verbindungen zwischen Leistungshalbleiterbauelementen 24 und zwischen Leiterbahnen 22 des Substrats 2 ausgebildet werden. Insbesondere bei Drucksinterverbindungen ist es vorteilhaft, wie dargestellt, eine isolierende Masse 28 am Randbereich der Leistungshalbleiterbauelement 24 anzuordnen. Diese isolierende Masse 28 kann auch in den Zwischenräumen der Leiterbahnen 22 angeordnet werden.

Zur elektrischen Anbindung weist die leistungselektronische Schalteinrichtung 1 Last-4 und Hilfsanschlusselemente auf, wobei hier nur die Lastanschlusselemente dargestellt sind. Diese Lastanschlusselement 4 sind rein beispielhaft als Metallformkörper ausgebildet, die mit einem Kontaktfuß mit einer Leiterbahn 22 des Substrats 2 stoffschlüssig, vorteilhafterweise ebenfalls mittels einer Sinterverbindung, verbunden sind. Grundsätzlich können auch Teile der Verbindungseinrichtung 3 selbst als Last- oder Hilfsanschlusselemente ausgebildet sein. Die Hilfsanschlusselemente, wie Gate- oder Sensoranschlüsse, können im Übrigen fachüblich ausgebildet sein.

Die Druckeinrichtung 5 weist eine erste 500 dem Substrat 2 zugewandte und eine zweite dem Substrat 2 abgewandte Hauptfläche 502 auf und ist hier der Übersicht halber beabstandet von der Verbindungseinrichtung 3 dargestellt. Die Druckeinrichtung 5 besteht aus einem Druckkörper 50 und einer Mehrzahl, dargestellt sind zwei, Druckelementen 52. Der Druckkörper 50 ist besonders starr ausgebildet um auf ihn eingeleiteten Druck homogen auf die Druckelemente 52 weitergeben zu können. Hierzu und vor dem Hintergrund der thermischen Belastungen beim Betrieb der Schalteinrichtung besteht der Druckkörper 50 aus einem hochtemperaturbeständigen thermoplastischen Kunststoff, insbesondere aus Polyphenylensulfid. Die Druckelemente 52 müssen im Betrieb und hierbei insbesondere bei unterschiedlichen Temperarturen einen im Wesentlichen konstanten Druck ausüben können. Hierzu bestehen die Druckelemente 52 aus einem Silikonkautschuk, insbesondere aus sog. Flüssig-Silikon.

Die Druckeinrichtung 5 weist in beiden orthogonalen Richtungen parallel zur Substratebene ein laterale Ausdehnung 540 auf, die geringer ist als die zugeordnete laterale Ausdehnung 200 des Substrats 2 selbst.

Figur 2 zeigt diese erste Ausgestaltung einer erfindungsgemäßen Anordnung 100. Diese Anordnung 100 weist eine erste leistungselektronische Schalteinrichtung 1 nach Figur 1, sowie einen die Kühleinrichtung 7 bildenden Kühlkörper und eine schematisch angedeutete Druckeinleiteinrichtung 6 auf.

Die Druckeileiteinrichtung 6 stützt sich, nicht dargestellt, gegen die Kühleinrichtung 7, ab. Dies kann mittelbar beispielhaft über eine Schraubverbindung zwischen der Druckeinleiteinrichtung und einem auf der Kühleinrichtung befestigten Gehäuse ausgeführt sein.

Die Druckeinleiteinrichtung 6 drückt hierbei mittig auf die Druckeinrichtung 5 der Schalteinrichtung 1. Der Druckkörper 50 der Druckeinrichtung 5 verteilt den Druck gleichmäßig auf die Druckelemente 52, die ihrerseits auf Abschnitte 342 der zweiten Hauptfläche 340 der Verbindungseinrichtung 3 drücken. Diese Abschnitte 342 der Verbindungseinrichtung 3, die mit Druck beaufschlagt werden sind erfindungsgemäß derart gewählt, dass sie und somit ihre Ausdehnungsfläche betrachtet in Normalenrichtung des zugeordneten Leistungshalbleiterbauelements 24 innerhalb der Fläche dieses Leistungshalbleiterbauelements 24 angeordnete sind. Somit drückt das Druckelement 52 mittels der Verbindungseinrichtung 3 derart auf das Leistungshalbleiterbauelement 24, dass dieses, genauer das darunter befindliche Substrat 2, auf den Kühlkörper 7 gedrückt wird und somit der thermische Kontakt vom Leistungshalbleiterbauelement 24 zum Kühlkörper 7 optimal ausgebildet ist.

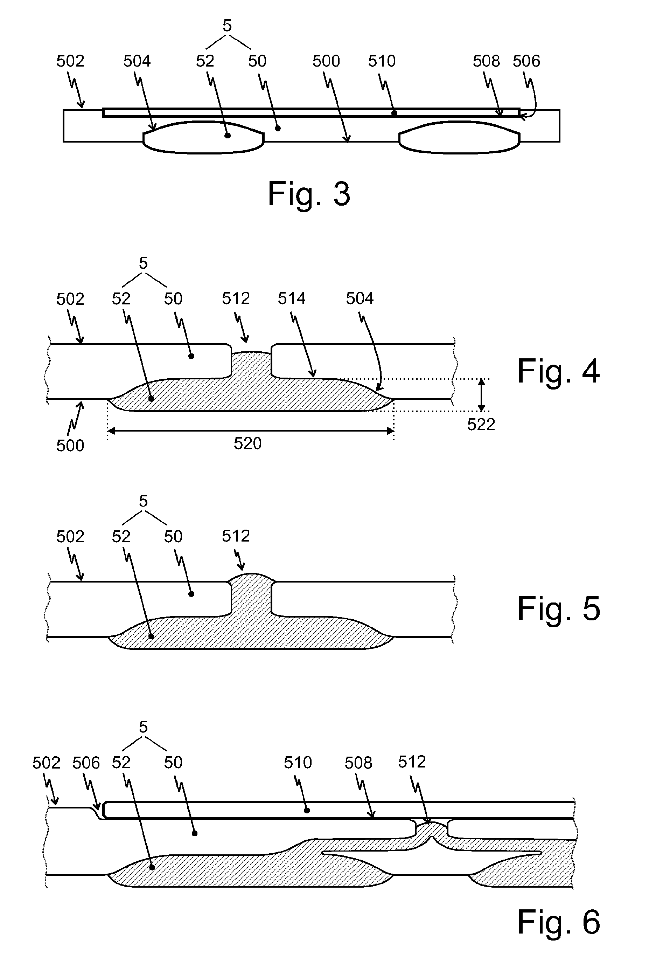

Durch diese Druckeinleitung auf die Druckelemente 52 verformen sich diese, wobei es hierbei auch möglich ist, dass ihre laterale Ausdehnung 342 zunimmt. Im unbelasteten Zustand, also ohne eingeleiteten Druck, vgl. Fig. 1, weist dieser Druckkörper 52 ein Verhältnis von seiner lateralen Ausdehnung 520 zu seiner vertikaler Ausdehnung 522 von 4 zu 1, vgl. zu den Dimensionen Fig. 4, auf. Im belasteten, also mit Druck beaufschlagtem Zustand und durch die dadurch verursachte Verformung des Druckkörpers 52 gemäß Fig. 2 verändert sich dieses Verhältnis nach 5 zu 1.

Zwischen dem Substrat 2 und dem Kühlkörper 7 ist eine Wärmeleitpaste 70 mit einer Dicke von weniger als 10µm angeordnet. Ein derart dünne Ausgestaltung einer Wärmeleitpastenschicht 70 ist unter Berücksichtigung latent vorhandener lokaler Durchbiegungen des Substrats 2 insbesondere dadurch möglich, dass der Druck in Normalenrichtung auf das Leistungshalbleiterbauelement 24 eingeleitet wird und somit das Leistungshalbleiterbauelement 24 und nicht eine umgebende Fläche den optimalen thermischen Kontakt zum Kühlkörper 7 aufweist.

Die Kühleinrichtung ist hier als Kühlkörper 7 zur Luftkühlung dargestellt, kann aber genauso als Grundplatte eines Leistungshalbleitermoduls oder als Kühlkörper zur Flüssigkeitskühlung ausgebildet sein.

Figur 3 zeigt eine Druckeinrichtung 5 einer zweite Ausgestaltung einer leistungselektronischen Schalteinrichtung. Der Druckkörper 50 der Druckreinrichtung 5 weist zusätzlich eine Metalleinlage 510 auf, die hier ohne Beschränkung der Allgemeinheit in einer zweite Ausnehmung 506 an der zweiten Hauptfläche 504 der Druckeinrichtung 5 angeordnet ist. Hierbei bildet die Basis dieser zweiten Ausnehmung 506 eine Hilfsfläche 508 aus, die den Druckkörper 50 begrenzt.

Figuren 4 bis 6 zeigen verschiedene Ausgestaltungen von Teilen der Druckeinrichtung, insbesondere einen Abschnitt des Druckkörpers mit einem Druckelement bzw. bei Fig. 6 mit zwei Druckelementen.

Fig. 4 zeigt einen Druckkörper 50 mit einer ersten von der ersten Hauptfläche 500 ausgehenden Ausnehmung 504, die nicht nur als Vertiefung, wie bei der Druckeinrichtung gemäß Fig. 1, sondern als Vertiefung mit einer Aussparung und einer Öffnung an der zweiten Hauptfläche 502 des Druckkörpers 50 ausgebildet ist, die von der ersten 500 bis zu zweiten Hauptfläche 502 reicht. Hierbei gilt für diese wie alle sonstigen derartigen Aussparungen 504, dass jeweils eindimensional betrachtet ihre lichte Weite an der ersten Hauptfläche 500 mindestens das fünf-, meist mindestens das zehnfache der lichten Weite an der zweiten Hauptfläche 502 entspricht, auch wenn dies in der schematischen Darstellung nicht ersichtlich ist.

Diese lichte Weite an der ersten Hauptfläche 500 ist identisch zur lateralen Ausdehnung 520 des Druckelements 52, während die vertikale Ausdehnung 522 des Druckelements 52 bis zur Basis 514 der ersten Ausnehmung 504, allerdings nicht in die Öffnung 512 zur zweiten Hauptfläche 502 des Druckkörpers 52 hinein, reicht.

Die laterale Ausdehnung 520 des Druckelements 52 nach Druckbeaufschlagung entspricht der lateralen Ausdehnung desjenigen Abschnitts 342 des Verbindungselements 3, der in Kontakt mit dem Druckelement 52 steht, vgl. Fig. 2.

Das Druckelement 52 besteht hier aus einem sog. Flüssig-Silikon, auch bekannt als Liquid Silicon Rubber (LSR), mit einer Shore A Härte von 20 bis 70, vorzugsweise von 30 bis 40. Diese wird mittels eines Zwei-Komponenten-Spritzgießverfahrens innerhalb des Druckkörpers 50, der aus Polyphenylensulfid besteht angeordnet. Hierzu kann das Flüssig-Silikon durch die Öffnung 512 der zweiten Hauptfläche 502 des Druckkörpers 50 eingebracht werden. In dieser Ausgestaltung der Druckeinrichtung 5 ist die Aussparung des Druckkörpers 50 nicht vollständig mit Flüssig-Silikon ausgefüllt, wodurch es nicht bis an die durch die zweite Hauptfläche 502 der Druckeinrichtung 5 definierten Ebene heranreicht.

Fig. 5 zeigt eine leicht abgewandelte Ausgestaltung der Druckeinrichtung 5 gemäß Fig. 4. Hierbei ist die Aussparung 504 des Druckkörpers 50 vollständig mit Flüssig-Silikon gefüllt. Das Flüssig-Silikon reicht über die durch die zweite Hauptfläche 502 der Druckeinrichtung 5 definierten Ebene hinaus und steht dort hervor.

Fig. 6 zeigt eine weitere Abwandlung der Druckeinrichtung 5, wobei diese analog zur Ausgestaltung gemäß Fig. 3 eine Metallseele 510 aufweist. Zudem sind die Aussparungen hier zweiter Druckelemente 52, allgemein einer Mehrzahl von Druckelementen, innerhalb der Druckkörpers 50 miteinander verbunden und weisen eine hier zur Hilfsfläche 508 gerichtete gemeinsame Öffnung 512 auf. Durch diese Öffnung 512 wird im Rahmen des Herstellungsverfahren der Druckeinrichtung 5 das Flüssig-Silikon in den Druckkörper 50 eingebracht.

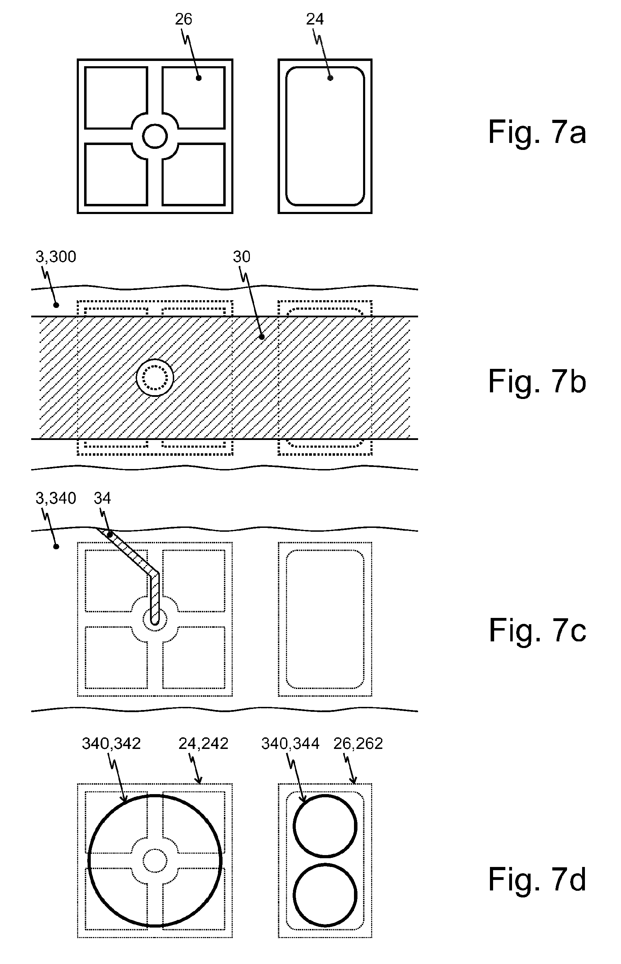

Figur 7 zeigt eine Draufsicht auf eine leistungselektronischen Schalteinrichtung 1 in verschiedenen Schnittebenen. Die Schnittebene gemäß Fig. 7a zeigt zwei Leistungshalbleiterbauelemente 24, 26, die typisch aber nicht dargestellt auf einer gemeinsamen Leiterbahn eines Substrats angeordnet sind. Es handelt sich hier ohne Beschränkung der Allgemeinheit um einen Transistor 26 mit einer mittigen Gateanschlussfläche und diese umrahmende Emitteranschlussflächen und um eine Diode 24 mit einer Kathodenanschlussfläche.

Fig. 7b zeigt die erste in sich strukturierte elektrisch leitende Folie 30 der Verbindungseinrichtung 3. Diese bildet eine elektrisch leitende Verbindung zwischen den Emitteranschlussflächen des Transistors 26 und der Kathodenanschlussfläche der Diode 24 aus. Hierbei wird die Gateanschlussfläche des Transistors 26 ausgespart.

Fig. 7c zeigt die zweite in sich strukturierte elektrisch leitende Folie 34 der Verbindungseinrichtung 3. Diese bildet eine elektrisch leitende Verbindung zur Gateanschlussfläche des Transistors 26.

Fig. 7d zweigt quasi den Fußabdruck der den Leistungshalbleiterbauelementen 24, 26 zugeordneten Kontaktelemente der Kontakteinrichtung, wobei dem Transistor aufgrund seiner quadratischen Grundform nur ein Kontaktelement und der Diode aufgrund ihrer rechteckigen Grundform zwei Kontaktelemente zugeordnet sind. Der jeweilige Fußabdruck entspricht denjenigen Abschnitten 342, 344 auf der zweiten Hauptfläche 304 der Verbindungseinrichtung 3, die in Normalenrichtung fluchtend zu den Leistungshalbleiterbauelementen angeordnet sind und hierbei auf das jeweilige Leistungshalbleiterbauelement projiziert sind. Hierbei wird ersichtlich, dass die Fläche des Fußabdrucks, also diejenige Fläche die zur Druckeinleitung bestimmt ist einen möglichst großen Teil der Fläche des Leistungshalbleiterbauelement abdeckt, ohne über diese hinauszugehen.

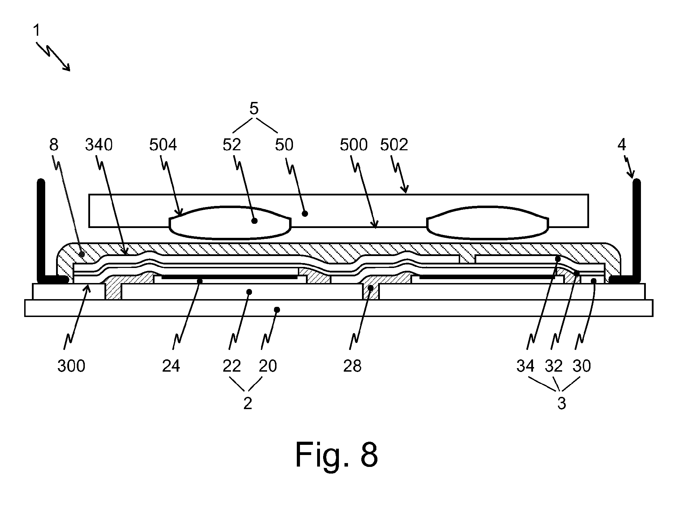

Figur 8 zeigt eine zweite Ausgestaltung einer erfindungsgemäßen leistungselektronischen Schalteinrichtung 1, die die erste Ausgestaltung gemäß Fig. 1 weiterbildet. Hierbei sind, um Anforderungen zum Schutz gegen Umwelteinflüsse, gerecht zu werden die Oberseite des Substrats 2, einschießend dessen Leiterbahnen 22, der Leistungshalbleiterbauelemente 24 und die Verbindungseinrichtung 3 mittels einer Vergussmasse 8, bespielhaft einem Epoxidharz, feuchtigkeitsdicht vergossen ist. Hierdurch ist eine Schutzart von IP 54 (internatioal protection code gemäß IEC 60529) und höher erreichbar. Vorteilhafterweise sind hierbei auch Teile der Anschlusselemente, insbesondere der Lastanschlusselemente 4 mit vergossen.

## Patentansprüche

1. Leistungselektronische Schalteinrichtung (1) mit einem Substrat (2), einem hierauf angeordneten Leistungshalbleiterbauelement (24, 26), einer Verbindungseinrichtung (3), Lastanschlusseinrichtungen (4) und einer Druckeinrichtung (5),
wobei das Substrat (2) gegeneinander elektrisch isolierte Leiterbahnen (22) aufweist und auf einer Leiterbahn (22) ein Leistungshalbleiterbauelement (24, 26) angeordnet und stoffschlüssig damit verbunden ist,
wobei die Verbindungseinrichtung (3) als Folienverbund mit einer elektrisch leitenden (30, 34) und einer elektrisch isolierenden Folie (32) ausgebildet ist und somit eine erste und eine zweite Hauptfläche (300, 340) ausbildet und wobei die Schalteinrichtung mittels der Verbindungseinrichtung (3) intern schaltungsgerecht verbunden ist,
wobei die Druckeinrichtung (5) einen Druckkörper (50) mit einer ersten Ausnehmung (504) aufweist aus der ein Druckelement (52) hervorstehend angeordnet ist und wobei das Druckelement (52) auf einen Abschnitt (342, 344) der zweiten Hauptfläche (340) des Folienverbunds drückt und hierbei dieser Abschnitt in Projektion entlang der Normalenrichtung des Leistungshalbleiterbauelements (24, 26) innerhalb der Fläche (242, 262) des Leistungshalbleiterbauelements (24, 24) angeordnet ist.

2. Schalteinrichtung nach Anspruch 1, wobei
die erste Ausnehmung (504) des Druckkörpers (50) ausschließlich als Vertiefung ausgehend von einer ersten Hauptfläche (500) oder als Vertiefung ausgehend von der ersten Hauptfläche (500) mit einer durch den Druckkörper (50) zur zweiten Hauptfläche (502) hindurchreichenden Aussparung mit dort ausgebildeter Öffnung (512) ausgebildet ist.

3. Schalteinrichtung nach Anspruch 2, wobei
das Druckelement (52) die Ausnehmung (504) des Druckkörpers (50) vollständig oder annährend vollständig ausfüllt.

4. Schalteinrichtung nach Anspruch 2 oder 3, wobei
das Druckelement (52) aus der Aussparung (504) des Druckkörpers an dessen zweiten Hauptfläche (502) hervorsteht.

5. Schalteinrichtung nach einem der vorhergehenden Ansprüche, wobei
der Druckkörper (50) aus einem hochtemperaturbeständigen thermoplastischen Kunststoff, insbesondere aus Polyphenylensulfid, und das Druckelement (52) aus einem Silikonkautschuk, insbesondere aus Flüssig-Silikon, besteht.

6. Schalteinrichtung nach einem der vorhergehenden Ansprüche, wobei
der Druckkörper (50) eine zweite Ausnehmung (506) auf seiner zweiten Hauptfläche (502) aufweist, deren Basis eine Hilfsfläche (508) bildet und wobei in der zweiten Ausnehmung (506) ein flächiger Metallkörper (510) angeordnet ist.

7. Schalteinrichtung nach einem der vorhergehenden Ansprüche, wobei
der Flächeninhalt des Abschnitts (342, 344) mindestens 20%, insbesondere mindestens 50% der Fläche (242, 262) des Leistungshalbleiterbauelements (24, 26) aufweist.

8. Schalteinrichtung nach einem der vorhergehenden Ansprüche, wobei
erste Leiterbahnabschnitte, gebildet aus der elektrisch leitenden Folie (30) der Verbindungseinrichtung (3), mit einer Kontaktfläche des Leistungshalbleiterbauelements (24, 26) und mit einer Leiterbahn (22) des Substrats (2) stoffschlüssig, insbesondere mittels Drucksintern, verbunden ist.

9. Schalteinrichtung nach einem der vorhergehenden Ansprüche, wobei
die laterale Ausdehnung (540) der Druckeinrichtung (5) in beide orthogonalen Richtungen parallel zur Substratebene geringer ist als die laterale Ausdehnung (200) des Substrats (2).

10. Schalteinrichtung nach einem der vorhergehenden Ansprüche, wobei
das Verhältnis aus laterale Ausdehnung (520) zu vertikaler Ausdehnung (522) des Druckkörpers (52) ein Verhältnis von 2 zu 1, insbesondere von 4 zu 1 aufweist.

11. Schalteinrichtung nach einem der vorhergehenden Ansprüche, wobei
die Oberseite des Substrats (2), einschießend dessen Leiterbahnen (22), das Leistungshalbleiterbauelement (24) und die Verbindungseinrichtung (3) mittels einer Vergussmasse (8) feuchtigkeitsdicht vergossen ist.

12. Anordnung (100) mit einer elektronischen Schalteinrichtung (1) nach einem der vorhergehenden Ansprüche, mit einer Kühleinrichtung (7) und mit einer Druckeinleiteinrichtung (6), wobei die Druckeinleiteinrichtung (6) sich mittelbar oder unmittelbar gegen die Kühleinrichtung (8) abstützt, mittig auf die Druckeinrichtung (5) Druck einleitet und hierdurch die Schalteinrichtung (1) kraftschlüssig mit der Kühleinrichtung (7) verbunden ist.

13. Anordnung nach Anspruch 12, wobei
zwischen Substrat (2) und der Kühleinrichtung (7) eine Wärmeleitpaste (70) mit einer Dicke von weniger als 20µm, insbesondere von weniger als 10µm, insbesondere von weniger als 5µm angeordnet ist.

14. Anordnung nach Anspruch 12, wobei
die Kühleinrichtung (7) eine Grundplatte eines Leistungshalbleitermoduls oder ein Kühlkörper ist.

15. Anordnung nach Anspruch 12, wobei
das Verhältnis aus laterale Ausdehnung (520) zu vertikaler Ausdehnung (522) des Druckkörpers (52) ein Verhältnis von 3 zu 1, insbesondere von 5 zu 1 aufweist.
